(19) Europäisches Patentamt
European Patent Office
Office européen des brevets

(11) Publication number: 0 111 932 B1

(12) EUROPEAN PATENT SPECIFICATION

(45) Date of publication of patent specification: 20.07.88

(51) Int. Cl.[4]: H 01 L 21/56, H 01 L 23/30

(21) Application number: 83112853.3

(22) Date of filing: 20.12.83

# (54) Resin-molded semiconductor devices and a process for manufacturing the same.

(30) Priority: 20.12.82 JP 224483/82

(43) Date of publication of application:
27.06.84 Bulletin 84/26

(45) Publication of the grant of the patent:
20.07.88 Bulletin 88/29

(84) Designated Contracting States:
DE FR GB

(56) References cited:
DE-A-2 944 922
GB-A-1 303 382
US-A-3 751 724
US-A-4 153 910

PATENTS ABSTRACTS OF JAPAN, vol. 5, no. 82(E-59)(754), 29th May 1981; & JP-A-56 29339 (ORIGIN DENKI K.K.) 24-03-1981

PATENTS ABSTRACTS OF JAPAN, vol. 6, no. 147(E-123)(1025), 6th August 1982 ; JP-A-57 69750 (HITACHI SEISAKUSHO K.K.) 28-04-88

(73) Proprietor: HITACHI, LTD.
6, Kanda Surugadai 4-chome Chiyoda-ku
Tokyo 100 (JP)

(72) Inventor: Hidaka, Toshiyuki
Chimeiryou, 3-1-26 Johnan-cho
Hitachi-shi Ibaraki-ken (JP)
Inventor: Sakamoto, Hisashi
2-28-21, Nakanarusawa-cho
Hitachi-shi Ibaraki-ken (JP)
Inventor: Fukuhara, Toshiaki
3-6-15, Ayukawa-cho
Hitachi-shi Ibaraki-ken (JP)
Inventor: Fujieda, Sadao
2-50, Naka-machi
Haramachi-shi Fukushima-ken (JP)
Inventor: Misawa, Yutaka
818-6, Tabiko
Katsuta-shi Ibaraki-ken (JP)

(74) Representative: Patentanwälte Beetz sen. - Beetz jun. Timpe - Siegfried - Schmitt-Fumian
Steinsdorfstrasse 10
D-8000 München 22 (DE)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 111 932 B1

**Description**

Background of the Invention

The present invention relates to a resin-molded semiconductor device and more specifically to a resin-molded axial lead-type semiconductor device.

Semiconductor devices have been extensively used which are obtained by sealing in an epoxy resion a sub-assembly in which a semiconductor pellet is held by between a pair of brazed axial leads. So far, however, the sub-assembly is sealed in the epoxy resion by using a metal mold. When a glass is to be used for the purpose of sealing, a slurry of glass is applied round a semiconductor pellet in the sub-assembly and is then baked. In this case, there is no need of employing a metal mold. When the epoxy resin is used, however, the metal mold must be employed unlike the case of using the glass. The reason is because there is available no one-can type epoxy resion which cures to some extent within a few minutes. Namely, such resin systems transform into a sol just before curing and the viscosity decreases strikingly relative to the viscosity at ordinary temperature. Accordingly, the resins would drop off from the sub-assembly without using a mold.

The Japanese Patent Laid-Open No. 1174/1980 discloses a method according to which the sub-assembly is sealed in a glass, and the epoxy resion is further applied thereto. In this case, however, the epoxy resin which is applied forms a film which is not thick enough to achieve the purpose of sealing.

According to the sealing method which is now put into practice with using epoxy resins, it is necessary to employ a metal mold. Therefore, cumbersome operation is required for setting the sub-assembly in the metal mold, injecting the epoxy resin, parting the sub-assembly from the metal mold, and the like. In particular, it is difficult to continuously perform the setting and parting, which seriously interferes with a mass-production. When a parting agent is contained in the epoxy resin to facilitate the parting operation, it reduces the adhesiveness between the resin and the leads, and gaps are often formed between the leads and the sealing layer in such semiconductor devices. Furthermore, water may infiltrate through the gaps and reach the semiconductor pellet; in such a case, the semiconductor device loses its characteristics in the reverse direction and further loses the reliability in operation.

The GB—A—1 303 382 discloses a method for manufacturing resin-molded semiconductor device comprising two steps of (1) horizontally holding the sub-assembly and coating a polyesterimide varnish onto the semiconductor pellet while rotating the sub-assembly on the axis of the axial leads as center and (2) curing the varnish while maintaining the sub-assembly stationary without rotationg it. In this method, the varnish is not thick enough to achieve the purpose of sealing, because the curing of the varnish is carried out without rotating the sub-assembly.

Summary of the Invention

The object of the present invention is to provide a process for manufacturing resin-molded semiconductor devices sealed in an epoxy resin which have high quality and reliability without employing a metal mold. The above problem is solved according to the claim. The subclaims refer to prefered embodiments.

The present invention relates to a process which comprises the steps of:

(A) preparing a sub-assembly consisting of a semi-conductor pellet brazed between a pair of axial leads,

(B) horizontally holding a sub-assembly and dropping a predetermined amount of an epoxy resin onto the semiconductor pellet while rotating the sub-assembly on the axis of the axial leads as center,

(C) curing the epoxy resin while rotating the sub-assembly in such a manner that the surface portions of the epoxy resin are hardened; and

(D) further curing the epoxy resin while maintaining the sub-assembly, stationary without rotating it and completely curing the epoxy resion, thereby forming a sealing layer of the epoxy resin around the side periphery of the semiconductor pellet.

Preferably, the heating is carried out 2 to 10 min at 160 to 180°C in step (C) and 3 to 24 h at 160 to 200° in step (D).

The invention also relates to semiconductor devices obtained by the above-mentioned process. The invention can be put into practice by using an epoxy resin which has a suitable degree of hardening property and a suitable thixotropic index.

Brief Description of the Drawings

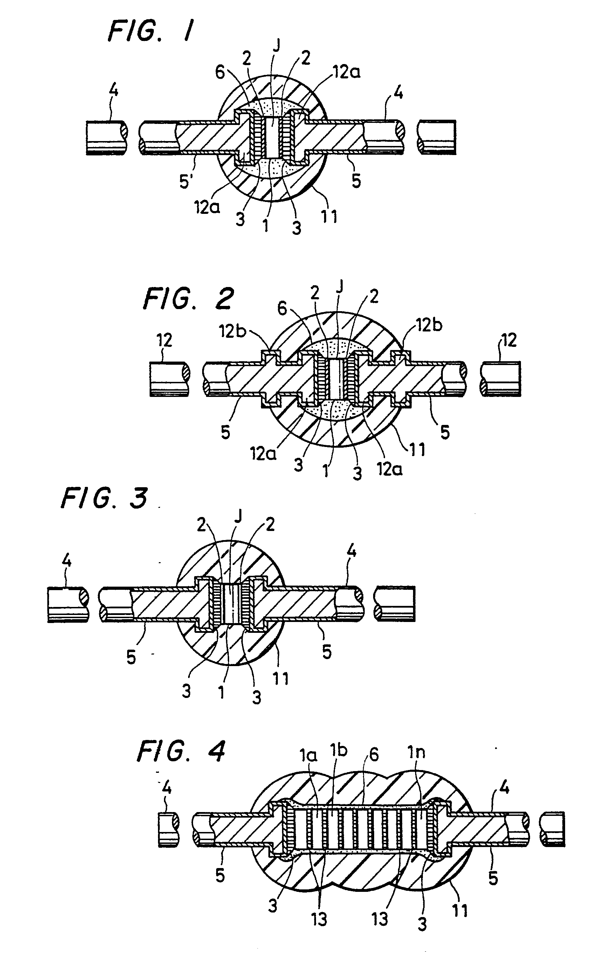

The figs. 1 to 4 are vertical section views of resin-molded semiconductor devices according to different embodiments of the present invention.

Detailed Description of the Invention

In fig. 1, a silicon pellet 1 having a pn junction J has nickel-plated layers 2 on its both surfaces so that the solderiong can be easily accomplished. The silicon pellet 1 is held between a pair of copper header leads 4 by soldering as designated at 3. Silver-plated layers 5 are formed on the surfaces of the header leads 4. To stabilize the surfaces of the pn junction J of the silicon pellet 1 of the thus constructed sub-assembly, a generally used surface-stabilizing material 6 such as a silicone resin is provided around the side periphery of the silicon pellet 1, and then a sealing layer is formed by using an epoxy resin.

According to a prefered embodiment of the invention, a one-can epoxy resin is used having epoxy groups in the molecules and containing 3 to 15 moles of an organic dibasic acid dihydrazide per 100 moles of the epoxy resin, and 2 to 7 moles of an imidazole compound represented by the following formula,

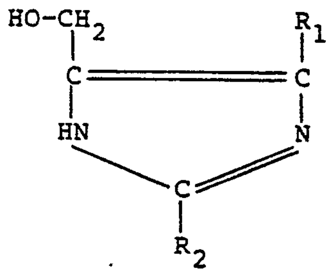

wherein $R_1$ is a methyl group, a hydrogen atom or a hydroxymethyl group, and $R_2$ is an alkyl group, per 100 moles of the epoxy resin.

It is also preferable to use a one-can epoxy resin which does not contain an organic dibasic acid dihydrazide, but contains only the imidazole compound represented by the above formula in an amount of 2 to 20 moles per 100 moles of the epoxy resin.

This resin exhibits a thixotropic index and hardening properties that are suited for the manufacturing process according to the invention which is described below. Preferably, such resins exhibit a viscosity ratio of 1.0 to 2.5, as measured by a rotation viscometer under the conditions of 4 turns a minute and 20 turns a minute (thixotropic index), and exhibits a gelation time of 0.8 to 3 min in a constant temperature bath.

By using this kind of resins, the device of the embodiment of fig. 1 is manufactured as described below.

First, a predetermined amount of the epoxy resin is dropped onto the sub-assembly which is provided with the surface-stabilizing material 6 and which is rotated at a speed of 2 turns a second with the leads 4 being held nearly horizontally. The resin will be required in an amount of about 0.05 g when it is to be applied to a length of 4 mm and to a diameter of 3.5 mm onto the sub-assembly in which the leads have a diameter of 0.6 mm and the header portions 12a have a diameter of 1.5 mm. As the sub-assembly rotates, the epoxy resion builds up in a shape as schematically shown in fig. 1. That is, in the portions where the epoxy resin comes into contact with the electrodes 4 or the surface-stabilizing material 6, it transforms into a sol due to the frictional forces produced by the rotation, whereby the viscosity decreases and the resin applies well onto the header leads 4 and the surface-stabilizing material 6. In the portions remote from the sub-assembly, on the other hand, the frictional forces are smaller and practically only the centrifugal force is acting on these portions. Therefore, the epoxy resin is not transformed into a sol and maintains the shape as indicated in fig. 1. Then, the surface only of the epoxy resin is hardened by heating while rotating the sub-assembly. Good results will be obtained if the epoxy resin is heated 2 to 10 min at 160° to 180°C. In this case, the epoxy resion in the surface is once transformed into a sol by the heat and its viscosity decreases conspicuously. However, the internal epoxy resin is not transformed into a sol and has a higher viscosity than the epoxy resin in the surface. Therefore, the represented shape is roughly maintained, and the surface portion only is hardened. The internal epoxy resin is confined by the hardened surface portion. At this moment, therefore, the epoxy resin no more drops from the sub-assembly despite it is not rotated; i.e., the epoxy resin which is applied thereto maintains its shape. Therefore, there is no need of rotating the sub-assembly. That is, rotation of the sub-assembly is stopped, and the epoxy resin is heated 3 to 24 h at 160° to 200°C so that it is perfectly cured up to its internal portion, at a different place as required. In the above-mentioned embodiment, the epoxy resin is cured by heating. The epoxy resin, however, can also be cured by the generally employed methods such as irradiation with ultraviolet rays, X-rays, infrared rays, and electron beams.

According to this process as described above, the sub-assembly can be molded without the need of using a metal mold. Therefore, the number of manufacturing steps can be reduced, and the manufacturing operation can be continuously carried out using automatic machines for the mass-production of those devices having constant quality.

The epoxy resin is cured after it is sufficiently applied to the header leads 4 or the surface-stabilizing material 6. Therefore, the sealing layer 11 is well adhering onto the header leads 4 or the surface-stabilizing material 6. Further, since the epoxy resin does not contain a parting agent, no gap develops between the leads and the sealing layer occurring in the prior art, and there are obtained semiconductor devices having an increased moisture resistance.

Fig. 2 illustrates another embodiment of the present invention, in which the portions same as, or corresponding to, those of fig. 1 are denoted by the same reference numerals.

This embodiment employs double header leads 12 which have flange portions 12b at positions separated away from the header portions 12a.

The flange portions 12b block the epoxy resin from flowing in the axial direction when it is being applied, work to trim the shape of the sealing layer 11, and contribute to a constant quality.

Fig. 3 shows a further embodiment of the present invention, in which the portions same as, or corresponding to, those of fig. 1 are denoted by the same reference numerals.

In this embodiment, no surface-stabilizing material is used, and the sub-assembly is directly wrapped in the sealing layer 11 composed of the epoxy resin.

The above-mentioned epoxy resin does not contain movable ions such as $Na^+$, $Cl^-$ or the like, that make the exposed surfaces of pn junction J of the silicon pellet 1 unstable. Therefore, the use of the surface-stabilizing material can be eliminated so far as the epoxy resin is not contaminated by movable ions such as $Na^+$, $Cl^-$ or the like. This helps to further reduce the number of manufacturing steps.

Fig. 4 shows still further embodiment of the present invention, in which the portions same as, or corresponding to, those of fig. 1 are denoted by the same refrence numerals.

In this embodiment, a plurality of silicon pellets 1a, 1b, - - - 1n having pn junctions (not shown) are laminated in a predetermined rectifying direction, adhered by a brazing material 13, and are then supported between the header leads 4 by brazing with a brazing material 3. The brazing material 3 has a melting point lower than that of the brazing material 13, such that the laminate of silicon pellets 1a, 1b - - - 1n is not deformed when it is being brazed to the header leads 4 with the brazing material 3. The silicon pellets 1a, 1b, - - - 1n of fig. 4 are not provided with plated nickel layers.

There will be obtained a withstand voltage which increases in proportion to the number of silicon pellets 1a, 1b, - - - 1n.

According to the process of the present invention, the sub-assembly can be molded sufficiently even if the distance is large between the two header leads 4.

According to the present invention as described above, it is possible to obtain resin-molded semiconductor devices which can be easily sealed in a contionuous manner without using molds which are suited for being mass-produced, and which maintain high quality and reliability.

**Claims**

1. A process for manufacturing resin-molded semiconductor devices comprising the steps of:

(A) preparing a sub-assembly consisting of a semiconductor pellet brazed between a pair of axial leads,

(B) horizontally holding the sub-assembly and dropping a predetermined amount of an epoxy resin onto the semiconductor pellet while rotating the sub-assembly on the axis of the axial leads as center,

(C) curing the epoxy resin while rotating the sub-assembly in such a manner that the surface portions of the epoxy resin are hardened, and

(D) further curing the epoxy resin while maintaining the sub-assembly stationary without rotating it and completely curing the epoxy resin, thereby forming a sealing layer of the epoxy resin around the side periphery of the semiconductor pellet.

2. A process according to claim 1, in which a one-can epoxy resin is used.

3. A process according to claim 1 or 2, in which an epoxy resin is used having a thixotropic index of 1.0 to 2.5 and a gelation time of 0.8 to 3 min.

4. A process according to one of claims 1 to 3, in which the epoxy resin is heated 2 to 10 min at a temperature of 160 to 180°C in step (C) and 3 to 24 h at 160 to 200°C in step (D).

5. A process according to one of claims 1 to 4, in which a one-can epoxy resin system is used containing 3 to 15 moles of an organic dibasic acid dihydrazide per 100 moles of the epoxy resin and 2 to 7 moles of an imidazole compound represented by the formula

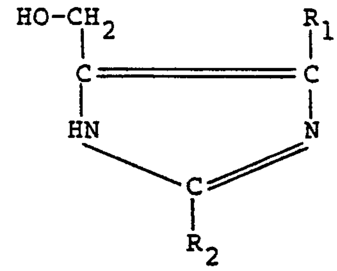

wherein $R_1$ is a methyl group, a hydrogen atom or a hydroxymethyl group and $R_2$ is an alkyl group, per 100 moles of the epoxy resin.

6. A process according to one of claims 1 to 4, in which a one-can epoxy resin system is used not containing an organic dibasic acid dihydrazide but containing 2 to 20 moles of an imidazole compound represented by the formula

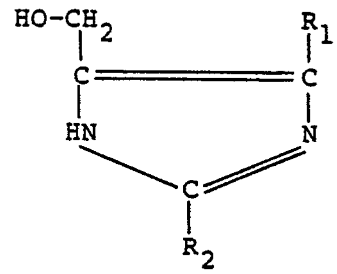

wherein $R_1$ is a methyl group, a hydrogen atom or a hydroxymethyl group and $R_2$ is an alkyl group, per 100 moles of the epoxy resin.

**Patentansprüche**

1. Verfahren zur Herstellung einer in einem Harz eingekapselten Halbleitervorrichtung mit den folgenden Stufen:

(A) Herstellen einer Unteranordnung aus einem zwischen einem Paar von Axialzuleitungen gelöteten Halbleiter-Pellet,

(B) waagerechtes Halten der Unteranordnung und Auftropfen einer vorbestimmten Menge eines Epoxyharzes auf das Halbleiter-Pellet, während sich die Unteranordnung auf der Achse der Axialzuleitungen als Zentrum dreht,

(C) Härten des Epoxyharzes während des Drehens der Unteranordnung so, daß die Oberflächenbereiche des Epoxyharzes gehärtet werden, und

(D) Weiterhärten des Epoxyharzes unter Ruhighalten der Unteranordnung ohne Drehen und vollständiges Härten des Epoxyharzes zu einer Abdichtungsschicht des Epoxyharzes um die Seitenperipherie des Halbleiter-Pellets.

2. Verfahren nach Anspruch 1, in dem ein Einkomponenten-Epoxyharz verwendet wird.

3. Verfahren nach Anspruch 1 oder 2, in dem ein Epoxharz mit einem Thixotrophie-Index von 1,0 bis 2,5 und einer Gelzeit von 0,8 bis 3,0 min verwendet wird.

4. Verfahren nach einem der Ansprüche 1 bis 3, in dem das Epoxyharz 2 bis 10 min auf eine Temperatur von 160 bis 180°C in Stufe (C) und 3 bis 24 h bei 160 bis 200°C in Stufe (D) erhitzt wird.

5. Verfahren nach einem der Ansprüche 1 bis 4, in dem ein Einkomponenten-Epoxyharzsystem verwendet wird, das 3 bis 15 mol eines organischen Dikarbonsäure-dihydrazids je 100 mol Epoxyharz und 2 bis 7 mol eines Imidazols der Formel

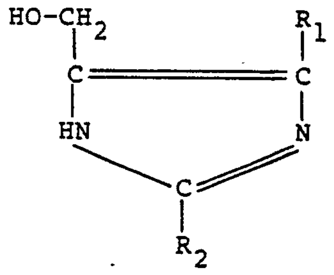

je 100 mol Epoxyharz enthält, wobei

$R_1$ eine Methylgruppe, ein Wasserstoffatom oder eine Hydroxymethylgruppe und

$R_2$ eine Alkylgruppe ist.

6. Verfahren nach einem der Ansprüche 1 bis 4, in dem ein Einkomponenten-Epoxyharzsystem verwendet wird, das kein organisches Dikarbonsäure-dihydrazid, jedoch 2 bis 20 mol eines Imidazols der Formel

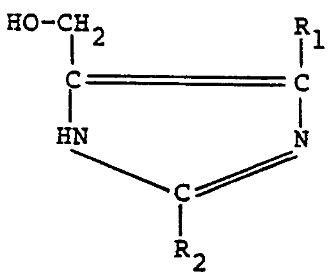

je 100 mol Epoxyharz enthält, wobei

$R_1$ eine Methylgruppe, ein Wasserstoffatom oder eine Hydroxymethylgruppe, und

$R_1$ eine Alkylgruppe ist.

**Revendications**

1. Procédé pour fabriquer dees dispositifs à semiconducteurs encapsulés dans une résine, incluant les étapes consistant:

(A) préparer un sous-ensemble constitué par une pastille semiconductrice fixée par brasage entre deux fils axiaux,

(B) maintenir horizontalement le sous-ensemble et faire tomber une quantité prédéterminée d'une résine époxy sur la pastille semiconductrice tout en faisant tourner le sous-ensemble autour de l'axe des fils axiaux en tant que centre,

(C) faire durcir la résine époxy tout en faisant tourner le sous-ensemble de manière que les parties de la surface de la résine époxy durcissent, et

(D) continuer à faire durcir la résine époxy tout en maintenant le sous-ensemble fixe sans la faire tourner, et faire durcir complètement la résine époxy de manière à former une couche de scellement en résine époxy autour du pourtour latéral de la pastille semiconductrice.

2. Procédé selon la revendication 1, selon lequel on utilise une résine époxy en un conteneur.

3. Procédé selon la revendication 1 ou 2, dans lequel on utilise une résine époxy possédant un indice de thixotropie compris entre 1,0 et 2,5 et une durée de solidification comprise entre 0,8 et 3 mn.

4. Procédé selon l'une des revendications 1 à 3, selon lequel on fait chauffer la résine époxy pendant 2 à 10 mn, à une température comprise entre 160 et 180°C lors de l'étape (C) et pendant 3 à 24 h entre 160 et 200°C lors de l'étape (D).

5. Procédé selon l'une des revendications 1 à 4, selon lequel on utilise un système de résine époxy en un conteneur, contenant 3 à 15 moles d'un dihydrazide d'acide dibasique organique pour 100 moles de la résine epoxy et 2 à 7 moles d'un composé imidazole représenté par la formule

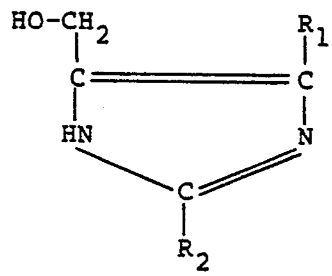

dans laquelle $R_1$ est un groupe méthyle, un atome d'hydrogène ou un groupe d'hydroxyméthyle, et

$R_2$ est un groupe alkyle,

pour 100 moles de la résine époxy.

6. Procédé selon l'une des revendications 1 à 4, selon lequel on utilise un système de résine époxy en un conteneur, qui ne contient pas d'hydrazide d'acide dibasique organique, mais contient 2 à 20 moles d'un composé imidazole représenté par la formule

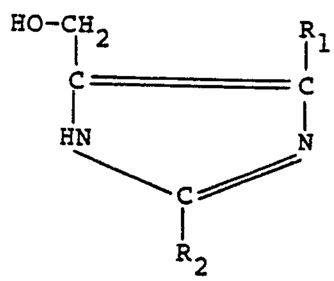

dans laquelle $R_1$ est un groupe méthyle, un atome d'hydrogène ou un groupe hydroxyméthyle, et

$R_2$ est un groupe alkyle,

pour 100 moles de la résine époxy.

FIG. 1

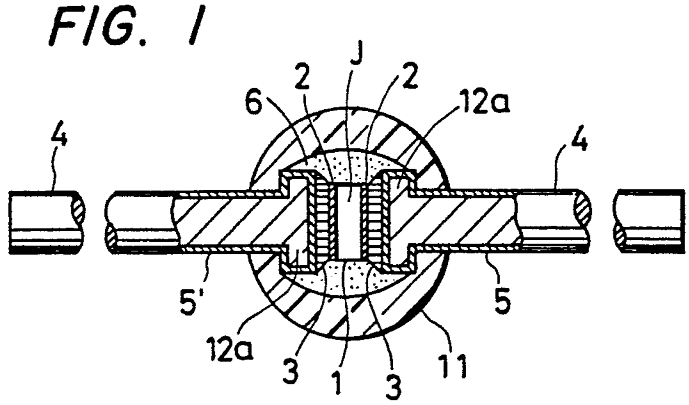


FIG. 2

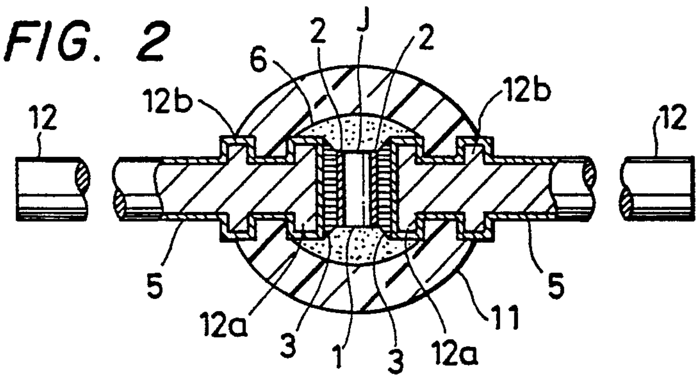


FIG. 3

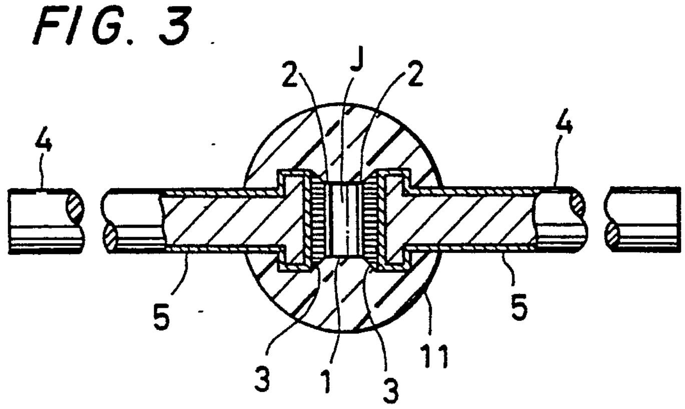


FIG. 4